Europäisches Patentamt

**European Patent Office**

**Office européen des brevets**

(11) Publication number: **0 060 654**
A1

# EUROPEAN PATENT APPLICATION

(21) Application number: **82301118.4**

(22) Date of filing: **04.03.82**

(51) Int. Cl.³: **G 01 S 13/36, H 03 B 9/14, H 03 D 9/06, H 01 Q 13/02**

(30) Priority: **13.03.81 ZA 811685**

(43) Date of publication of application: **22.09.82**
**Bulletin 82/38**

(84) Designated Contracting States: **AT BE CH DE FR GB IT LI NL SE**

(71) Applicant: **PLESSEY SOUTH AFRICA LIMITED, 64-74 White Road, Retreat 7945 Cape (ZA)**

(72) Inventor: **Downing, Barry John, 28, Second Crescent, Fish Hoek, 7975 (ZA)**

(74) Representative: **Jones, Graham Henry, THE PLESSEY COMPANY plc Vicarage Lane, Ilford, Essex (GB)**

(54) **Improvements in or relating to electronic distance measuring instruments.**

(57) A microwave head for use with electronic distance measuring systems in which the distance measurement depends on the measurement of the phases of intermodulation products of the modulations of transmitted and received signals, using the same plane of polarisation for the transmit and receive function. The microwave head comprises generator means (110) for generating a microwave carrier, tuner means (115) for tuning the microwave carrier, modulator means (115) for modulating the microwave carrier, heterodyning means for heterodyning the modulated carrier with a modulated received carrier, common collimating means for collimating the transmitted carrier and focusing the received carrier and means for causing the local oscillator bias energy to dominate any microwave power reflected back towards the heterodyning means from the common collimating means.

MICROWAVE HEAD FOR HIGH ACCURACY ELECTRONIC DISTANCE MEASURING
INSTRUMENTS.

This invention relates to electronic distance measuring
systems and to microwave heads for use therewith.

The present invention provides a microwave head for use
with electronic distance measuring systems in which the
distance measurement depends on the measurement of the phases
of intermodulation products of the modulations of transmitted
and received signals, which microwave head comprises generator
means for generating a microwave carrier, tuner means for
tuning the microwave carrier, modulator means modulating the
microwave carrier, heterodyning means for heterodyning the
modulated carrier with a modulated received carrier, common
collimating means for collimating the transmitted carrier and
focusing the received carrier and characterised by the use of
the same plane of polarisation for the transmit and receive
function, and means for causing the local oscillator bias
energy to dominate any microwave power reflected back towards
the heterodyning means from the common collimating means.

The generator means and the heterodyning means may
comprise a self-mixing oscillator. The microwave head may
include a parabolic reflector and the self- mixing oscillator
may be used as a primary feed into the parabolic reflector.
The parabolic reflector may be an offset parabolic reflector.

The generator means and the heterodyning means may be in
two microwave cavities arranged side by side, parallel to each
other, and in close proximity.

0060654

The heterodyning means may be a high barrier voltage mixing diode.

The present invention also provides an electronic distance measuring system including the microwave head.

In order to facilitate a complete and thorough understanding of the invention, reference will now be made to the following drawings in which Figures 1 to 5 illustrate prior devices and in which:

Figure 1 shows first apparatus for directly transmitting measuring waves;

Figure 2 shows second apparatus for directly transmitting measuring waves;

Figure 3 shows the apparatus of Figure 2 combined with a microwave head for converting the measuring waves into a modulated carrier and vice versa;

Figure 4 shows in block diagram form, the functions performed by the microwave head used in Figure 3;

Figure 5 shows a microwave head configuration having a transmit and receive collimating function;

Figure 6 shows a device in which a self-mixing oscillator is used for both transmitting and receiving a modulated carrier;

Figure 7 shows an offset parabolic reflector acting as a main collimating device; and

Figures 8 and 9 shows an alternative embodiment to that shown in Figure 7, Figure 9 being a section on the line A-A shown in Figure 8.

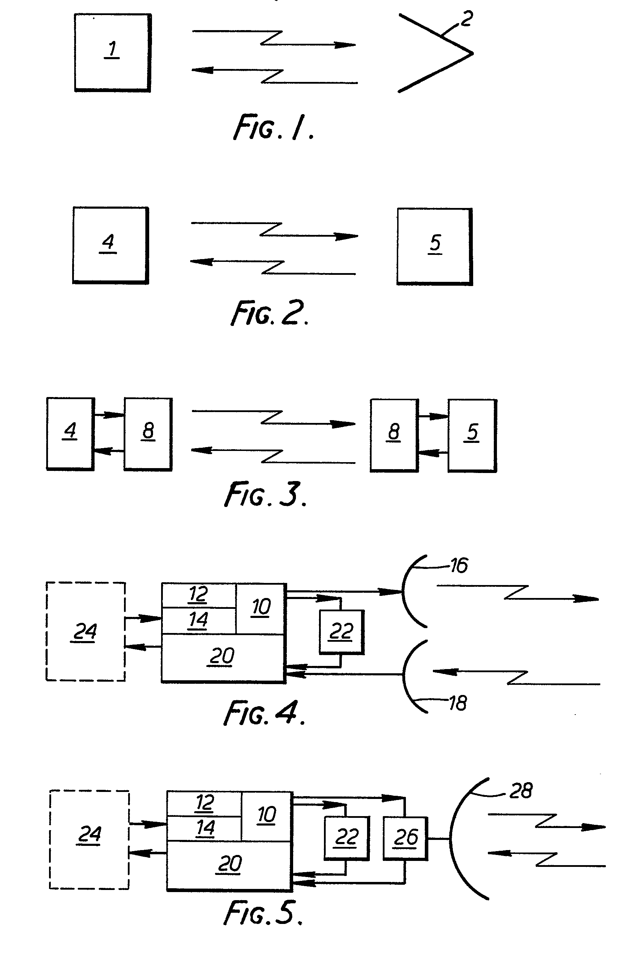

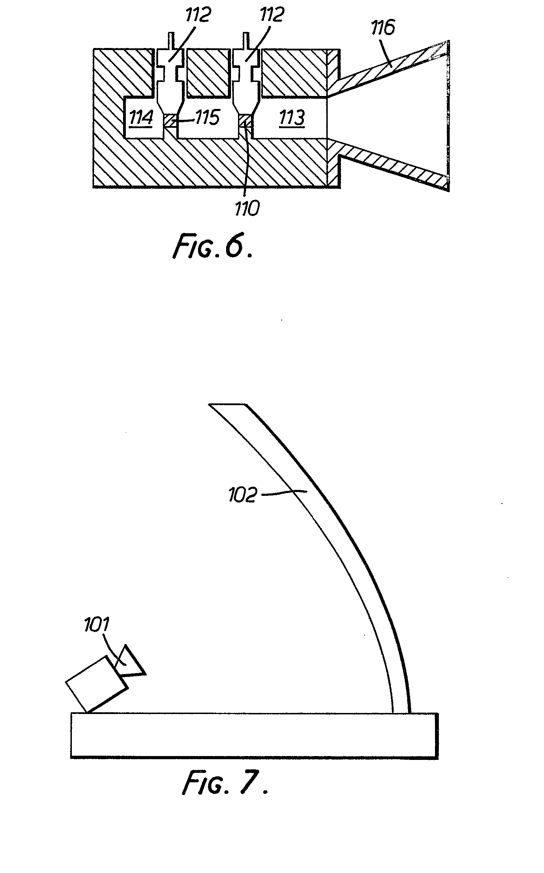

Referring generally to Figures 1 and 2 of the drawings, it is known that instruments that electronically measure distance, basically measure the time it takes for electromagnetic radiation to transit a distance to be measured and relate this time to distance via the known speed of propagation of the radiation. Although there are a number of ways in which the measure of the transit time can be obtained, the most commonly used is either the pulse system, wherein the time taken for an electromagnetic pulse to travel a distance and after reflection return to the point of transmission is measured, or the phase measuring system wherein a continuous wave of known frequency is transmitted and the phase of the wave after travelling the distance is compared to the phase at the start and the phase difference measured accurately.

Phase measuring systems are inherently capable of achieving the accuracies required by land surveyors, and medium priced electronic distance measuring instruments for land surveying are all based on this principle. A description of such a phase measuring system can be found in the specification of U.K. Patent No. 811,762 and in the Transactions of the South African Institute of Electrical Engineers of May 1958 at page 143.

In general such instruments have means to generate measuring waves of precisely known frequencies, means of transmitting these waves along the path to be measured, means to receive such frequencies, and means to accurately determine the phase relationships between transmitted and received frequencies. These instruments come in two measuring configurations.

In one configuration which is shown in Figure 1, the instrument 1 is positioned at one end of the path, the distance of which is to be measured, and a reflector is positioned at the other end. The measuring waves generated in the instrument 1 travel the path and are returned to the instrument 1 via a reflector 2, whereat they are received and the transit time determined by means of measurements of the phase differences between transmitted and received measuring waves.

In the other configuration which is shown in Figure 2, instruments 4 and 5 are placed one at each end of the path and from each instrument measuring waves are transmitted towards the other instrument where they are received and compared with the locally generated waves. The result of these comparisons at one of the instruments is transmitted to the other instrument where the phase differences between these comparisons and the local comparisons result in a final measure of the transit time.

The accuracy of the distance measurement so obtained is the theory determined by two factors inherent to the instrument, i.e. the accuracy with which the frequencies of the measuring waves are known and the accuracy to which the relative phases can be measured, and by one external factor, i.e. the accuracy with which the speed of propagation of the waves along the path is known.

It is in principle possible to transmit the measuring waves directly as shown in Figure 1 and Figure 2. However such a system would only perform well in free space since the propagation speed of the relatively low measuring frequencies is seriously affected by ground effects along the path.

In practice the measuring waves are transmitted along the path as modulations on a carrier wave of a high frequency, and either a microwave or a light wave is used as a carrier. Instruments using light as a carrier usually use the configuration of Figure 1, while microwave carrier instruments usually use the configuration of Figure 2.

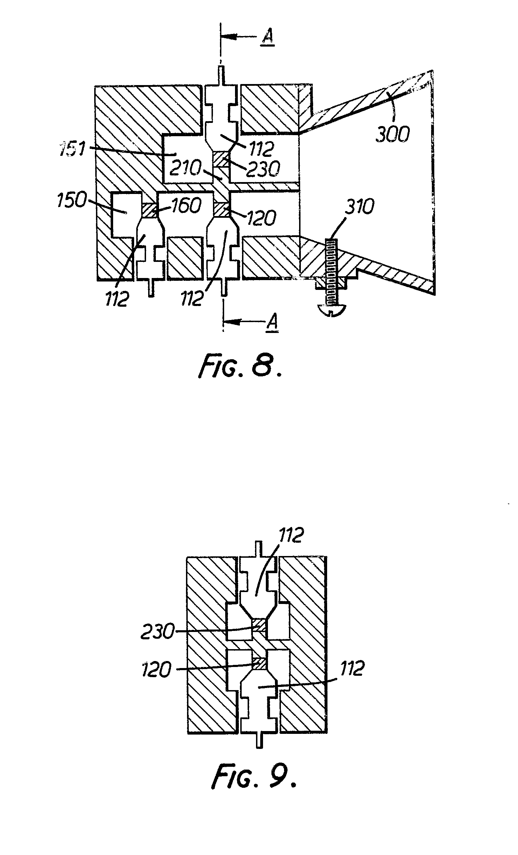

The conversion of the measuring waves into a modulated carrier and vice versa takes place in an additional device as shown in Figure 3. In the case where the carrier is a microwave, this additional device is usually referred to as a microwave head. In Figures 3, two microwave heads 8 are shown. Each microwave head 8 may be joined with its associated instrument 4 or 5 as one unit, or each microwave head 8 may consist of a separate unit connected to the instrument 4 or 5 by means of cables.

Figure 4 shows in block diagram form the functions performed by a microwave head 8. More specifically the microwave head 8, shown in Figure 4 contains generator means 10 for generating the microwave carrier, tuner means 12 for tuning the carrier frequency, modulator means 14 for modulating the microwave carrier, collimating means 16 for collimating the microwave energy and projecting it along the path, focussing means 18 for focussing the energy returned along the path onto a receiving device, detecting means 20 for detecting the received radiation, and bias means 22 for supplying local oscillator bias, derived from the modulated carrier wave generated by the generator means 10, to the detecting means 20. The intermodulation products of the received modulated carrier and the fraction of the transmitted modulated carrier, generated in the detecting means 20, are returned to the instruments 4 or 5 for processing. Although the microwave head 8 plays a passive role in the measuring process, certain of its features do affect the measuring accuracy of the combination of the microwave head 8 and the instrument 4 or 5.

In instrument head combinations using light as a carrier, the carrier wavelength is extremely short and even with a pair of collimating lenses, one for the transmit function and one for the receive function, it is possible to obtain nearly perfect collimation without such a system becoming unduly bulky. As a result, the received signal contains virtually no components derived from reflections from objects beside the path. In such instruments, the accuracy is only limited by the performance of the instrument 24 shown in Figure 4 and such instruments can obtain very high accuracies. However, due to atmospheric absorption, their range performance is limited to a few km under conditions of good visibility.

With microwave instruments the situation is different. High degrees of collimation comparable to those of light carrier instruments would require enormously bulky collimating systems. This is not acceptable in a field instrument. Even at the highest practical microwave frequency, (35GHz to date) a practical antenna system will have a beam width of a few degrees. As a result the signal received by such a system is made up of a main component transmitted via the direct measuring path and components derived from signals reflected from bodies beside the path. The latter components have travelled a longer distance. This multi-path reception thus results in measurement errors. The major reflecting body, virtually always in close proximity to the direct path, is the ground. These errors are often referred to as ground effect. The magnitude of ground effect errors is a function of the beam width and, in order to obtain the tightest possible beam for a given size of the collimator, the collimating devices for the transmit and receive functions are often combined into one, leading to the microwave head configuration shown in Figure 5. In Figure 5 parts corresponding to those shown in Figure 4 bear as appropriate the same numbered designations. In Figure 5, the transmitter wave and the received wave are combined in combiner means 26 and are both collimated in a collimating device 28. Although in this way a relative improvement in ground effect errors is obtained, it also introduces a new source of error generally referred to as antenna error, resulting from the standing wave ratio of the collimating device 28. Thus most of the energy from the generator means 10 is collimated by the collimating device 28 and transmitted along the path, but a small percentage is reflected back from it and can end up via the combiner means 26 at the detecting means 20, where it competes with the local oscillator bias deliberately inserted via the bias means 22, resulting in a measurement error. The following example shows the magnitude of this problem.

Assume that the source of carrier energy from the instrument 10 produces 50mW of microwave power and that the antenna collimating device 28 has a standing wave ratio of 1.5. That is it reflects 4% of the 50mW or 2mW back into the combiner means 26. If the combiner means 26 is a circulator, all of the 2mW ends up at a mixer diode where it competes with a deliberate local oscillator bias of 1mW inserted via the bias means 22. If a circulator is used as the combiner means 26, a further error is introduced due to the delay through it, since it is temperature and frequency dependent. Such a system characterised by the transmit path through the system having the same plane of polarisation as the receive path through it, leads to large antenna errors and is only used in applications with low accuracy requirements, e.g. measuring the position of a ship at sea where errors of a meter are acceptable.

In instruments used for land surveying purposes, the antenna error resulting from the common collimator is kept down to a reasonable magnitude by using as the collimator a parabolic reflector or a combination of a hyperbolic sub-reflector and a parabolic main reflector. Such a reflector system can collimate waves of any plane of polarisation. This property is used to obtain separation between the transmit and the received function of the antenna by arranging the planes of polarisation of the receive and transmit paths at square angles to each other. In such a cross polarised system, the transmit power reflected back from the antenna would not affect the mixer diode because the latter is insensitive to the plane of polarisation of the transmitter. In practice the separation so obtained is less than prefect due in part to the bias means 22 and due in part to the fact that the back scatter from the reflectors is partly depolarised. Nevertheless, a considerable improvement over the common polarisation system is obtained and antenna error can be kept down to a few cm.

The combined errors of microwave distance measuring instruments due to the antenna and ground effects are unacceptably large for relatively short range measurements but at long ranges are masked by the finite accuracy to which the speed of propagation is known. The result is that in land surveying practice, short range measurements are mostly done with light carrier instruments and long range measurements with microwave instruments.

The illustrated embodiments of the invention hereinbelow discussed aim to improve the measuring accuracy of a microwave instrument as far as both ground effect and antenna errors are concerned, thereby making it possible to measure also shorter ranges with acceptable accuracy.

According to the illustrated embodiments of the invention, accuracy improvements of the microwave head are obtained from the combination of:

    1.  The use of a common plane of polarisation for the receiver and transmit functions of the microwave head.

    2.  Measures to establish dominance of the mixer bias over the microwave energy reflected back from the collimating device.

In a preferred embodiment of the invention, a socalled self-mixing oscillator is used for both transmitting and receiving the modulated microwave carrier. An example of such a device is shown in Figure 6 and consists of a microwave cavity 114 in which are mounted a gunn diode 110 and a varactor 115.

Both are decoupled from the outside of the cavity 114 by microwave chokes 112 as is usual for such devices. Compared to the functional block diagram of Figure 5, the varactor 115 fulfils the functions of the means 12, 14, tuning the cavity 114 and FM modulating the carrier. The gunn diode 110 fulfils the functions of the means 10, 20, of generating the microwave power and heterodyning this with the received signal in a mixer role, while automatically satisfying the functions of the means 22, 26.

A horn 116 is mounted on the open end 113 of the cavity 114 and can function as the collimating device 28. Alternatively, a short horn 101 as shown in Figure 7 can serve to pre-shape the beam, while an offset-parabolic reflector 102 acts as the main collimating device.

It is well known that a self-mixing oscillator can be used as a receiving device. It is however in communication applications not very useful in a duplex role, where it transmits and receives at the same time, since the transmitted modulated carrier produces unwanted intermodulation products between that modulated transmitted carrier and the modulated received signal. In electromagnetic distance measuring instruments of the kind under discussion, it is precisely these intermodulation products which are desired.

A drawback of the self-mixing oscillator is that though it makes an efficient generator of microwave power, it is a very inefficient receiver. However this does not preclude its use in a distance measuring instrument because, even at its low receive sensitivity, it has been found capable of measuring distances in excess of 50km. The considerable improvement in measurement accuracy obtained from a microwave head using a self-oscillating mixer can be explained as follows:

A reduction in ground errors is a result of the common plane of polarisation of the received and transmitted waves. Ground reflections which follow a signal path only slightly deviating from the direct path produce relatively small errors because the excess path length relative to the direct path is small.

Reflections with a signal path deviating widely from the directly path produce relatively small errors because the limited antenna beam width ensures that the direct path signal is very dominant. Reflections at intermediate angles of a few degrees are responsible for the majority of the measurement errors. If the polarisation of both the transmitted and received signals are at square angles to the reflecting surface such signals are only weakly reflected. In fact, the reflection coefficient for such a polarisation goes through a minimum at an angle of approximately 5°. It was however hitherto not possible to exploit this property of reflections in a high accuracy instrument because the common plane of polarisation between transmit and receive functions led to very large antenna errors. If a self-mixing oscillator is used, this is no longer the case and full use can be made of this reflective property to upgrade the accuracy.

The reason a self-mixing oscillator does not suffer from large antenna errors is due to the highly dominant character of what, in the self-mixing oscillator, is the equivalent of what the mixer bias is in a separate mixing device.

The mixer bias in a self mixing gunn-diode oscillator as described in the above example is set by the energy in the microwave cavity. Part of that energy escapes out of the cavity into the collimating device. A small part of that energy is reflected back to the gunn-diode but due to the poor match of the gunn-diode as a receiver, only part of that energy is absorbed, and part is reflected out of the antenna again. The result is that the power reflected back from the collimator has only little effect on the measurement. Furthermore, the still remaining antenna error can be further reduced due to the compact structure of the self-mixing oscillator, which makes it practical to use the device as a primary feed into a reflector antenna. If an offset parabolic reflector is used, the standing wave ratio of such a combination of self-mixing oscillator source in primary feed configuration with an offset parabolic reflector can be made to exhibit a very low standing wave ratio. In such a configuration, there is virtually no antenna error and the benefits of the common plane of polarisation are fully realised. An example of such a combination is shown in Figure 7.

A useful but less preferred embodiment of the invention is shown in Figures 8 and 9. In this embodiment of the invention, a gunn oscillator 120 and a varactor 160 are mounted in a microwave cavity 150 in the same manner and fulfilling the same functions as the device shown in Figure 6. However no use is made of its capability to operate as a receiver.

Instead a separate mixer diode 230 is mounted in a cavity 151. The cavity 151 parallel with and very close to the gunn oscillator cavity 150. Both cavities are coupled to a common horn collimator 300 which also functions to combine the receive and transmit functions (Figure 5 - combiner means 26). The common horn collimator 30 may be shaped to function as the main collimator (Figure 5 - collimating device 28) or as a pre-collimator as shown in Figure 8, to work with a separate main collimator offset parabolic reflector 102 as shown in Figure 7.

In this embodiment of the invention illustrated in Figure 8, the mixer diode 230 should preferably use a type of a material having a relatively high barrier voltage, such as a gallium arsenide. Such a device requires relatively large local oscillator power which is derived by reflecting a fraction of the power generated by the gunn diode oscillator back towards the mixer diode by means of a deliberate mismatch in the transmit path. In Figure 8, the mismatch is achieved by a screw 310 located in the wall of the horn 300.

Such a system has in common with the preferred embodiment that it provides an inefficient receive function, since only half the received energy enters the cavity in which the detector diode 230 is mounted, the detector diode 230 being mounted on a post 210. However the loss of receiver efficiency is less severe than the loss suffered in the self-mixing oscillator embodiment. In exchange for this, the antenna error is not as effectively suppressed as in the preferred embodiment and extra care is necessary to keep the standing wave ratio of the collimating structure as low a possible.

It is to be appreciated that the embodiments of the invention described above with reference to the accompanying drawngs has been given by way of example only and that modifications may be effected.

This invention also extends to any one of the above desired features taken singly or in any combintion.

CLAIMS:

1.   A microwave head for use with electronic distance measuring systems in which the distance measurement depends on the measurement of the phases of intermodulation products of the modulations of transmitted and received signals, which microwave head comprises generator means for generating a microwave carrier, tuner means for tuning the microwave carrier, modulator means for modulating the microwave carrier, heterodyning means for heterodyning the modulated carrier with a modulated received carrier, common collimating means for collimating the transmitted carrier and focusing the received carrier and characterised by the use of the same plane of polarisation for the transmit and receive function, and means for causing the local oscillator bias energy to dominate any microwave power reflected back towards the heterodyning means from the common collimating means.

2.   A microwave head as claimed in claim 1 wherein the generator means and the heterodyning means comprise a self-mixing oscillator.

3.   A microwave head as claimed in claim 2 including a parabolic reflector, wherein the self mixing oscillator is used as a primary feed into the parabolic reflector.

4.   A microwave head as claimed in Claim 3 wherein the parabolic reflector is an offset parabolic reflector.

5.   A microwave head as claimed in any preceding claim wherein the generator means and the heterodyning means are in two microwave cavities arranged side by side, parallel to each other, and in close proximity.

6.   A microwave head as claimed in any preceding claim wherein the heterodying means comprises a high barrier voltage mixing diode.

7.   A microwave head as claimed in claim 1 and substantially as herein described with reference to the accompanying drawings.

8.   An electronic distance measuring system including a microwave head as claimed in any preceding claim.

1/3

FIG. 1.

FIG. 2.

FIG. 3.

FIG. 4.

FIG. 5.

112    112    116

114    115    113

110

FIG. 6.

102

101

FIG. 7.

0060654

FIG. 8.

FIG. 9.

**European Patent Office**

**EUROPEAN SEARCH REPORT**

EP 82 30 1118.4

## DOCUMENTS CONSIDERED TO BE RELEVANT

| Category | Citation of document with indication, where appropriate, of relevant passages | Relevant to claim |
|---|---|---|
| A | Patent Abstracts of Japan Vol. 4, No. 138, 27 September 1980 page 135P29 & JP - A - 55 - 89765 | 1 |
| A | DE - B2 - 2 126 470 (BENDIX) * column 2, lines 20 to 24; fig. 1 * & US - A - 3 659 293 | 2 |
| A | GB - A - 1 525 514 (A.W. RUDGE et al.) * fig. 1 * | 3,4 |
| A | US - A - 3 980 974 (S. YAMAMOTO et al.) * fig. 1 * | 5 |
| A | DE - A1 - 2 853 205 (HITACHI) * fig. 1 * & GB - A - 2 010 036 | |
| A | DE - B2 - 2 744 883 (ENDRESS U. HAUSER) * fig. 1 * | |
| A | US - A - 4 156 874 (F.B. KOPIS) * column 2, lines 47 to 56; fig. 1 * | 1 |
| A | DE - B2 - 1 941 453 (SIEMENS-ALBIS) * fig. 1 * | |
| A | EP - A1 - 0 021 872 (THOMSON-CSF) * fig. 1, 2 * | |

**CLASSIFICATION OF THE APPLICATION (Int. Cl. 3)**

G 01 S 13/36
H 03 B 9/14
H 03 D 9/06
H 01 Q 13/02

**TECHNICAL FIELDS SEARCHED (Int.Cl. 3)**

G 01 S 7/02
G 01 S 11/00
G 01 S 13/08
G 01 S 13/32
G 01 S 13/34
G 01 S 13/36
G 08 G 1/16
H 01 Q 1/24
H 01 Q 13/02
H 03 B 9/12
H 03 B 9/14
H 03 D 9/06

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

The present search report has been drawn up for all claims

| Place of search | Date of completion of the search | Examiner |
|---|---|---|
| Berlin | 07-06-1982 | BREUSING |

EPO Form 1503.1 06.78